Europäisches Patentamt

European Patent Office

Office européen des brevets

(19)

(11) Veröffentlichungsnummer : **0 116 364**
**B1**

# (12) EUROPÄISCHE PATENTSCHRIFT

(45) Veröffentlichungstag der Patentschrift :
18.06.86

(21) Anmeldenummer : 84101214.9

(22) Anmeldetag : 07.02.84

(51) Int. Cl.⁴ : **H 01 F 7/22**, G 01 N 24/06

(54) Kühleinrichtung für ein Tieftemperatur-Magnetsystem.

(30) Priorität : 09.02.83 DE 3304375
08.03.83 DE 3308157

(43) Veröffentlichungstag der Anmeldung :
22.08.84 Patentblatt 84/34

(45) Bekanntmachung des Hinweises auf die Patenterteilung : 18.06.86 Patentblatt 86/25

(84) Benannte Vertragsstaaten :
CH DE FR GB LI

(56) Entgegenhaltungen :
DE-A- 1 539 064
FR-A- 2 417 833
REVIEW OF SCIENTIFIC INSTRUMENTS, Band 50, Nr.
11, November 1979, Seiten 1382-1385, J. YAMMOTO
et al.: "Precooling of a superconducting magnet
using a cryocooler and thermal switches"
PATENTS ABSTRACTS OF JAPAN, Band 6, Nr. 103(E-
112)(981), 12. Juni 1982
MESSTECHNIK, Band 80, Nr. 11, November 1972,
Seiten 328-333 H. REGEL et al.: "Kernresonanzspektroskopie mit supraleitenden Magneten"

(73) Patentinhaber : **Bruker Analytische Messtechnik GmbH**
**Silberstreifen**
**D-7512 Rheinstetten-Forchheim (DE)**

(72) Erfinder : **Keller, Tony W.**
**Odenwaldstrasse 14**
**D-7512 Rheinstetten 1 (DE)**
Erfinder : **Müller, Wolfgang, Dr.**
**Im Speltel 56**
**D-7500 Karlsruhe 41 (DE)**

(74) Vertreter : **Patentanwälte Kohler - Schwindling - Späth**
**Hohentwielstrasse 41**
**D-7000 Stuttgart 1 (DE)**

EP 0 116 364 B1

Jouve, 18, rue St-Denis, 75001 Paris, France

**Beschreibung**

Die Erfindung geht aus von einer Kühleinrichtung für ein Tieftemperatur-Magnetsystem, bei dem eine einen Probenraum umschließende Magnetspule von wenigstens einem Zwischenschild umgeben in einer evakuierten Außenhülle angeordneter, motorisch angetriebener Refrigerator vorgesehen ist, der über einen durch die Außenhülle führenden Kühlarm das (die) Zwischenschild(e) kühlt.

Auf verschiedenen Gebieten der Meßtechnik, insbesondere der analytischen Maßtechnik und der medizinischen Meßtechnik, werden homogene Magnetfelder hoher Feldstärke benötigt. Hierzu werden in immer größerem Umfange anstelle der klassischen Eisenmagnete supraleitende Magnete eingesetzt. Diese supraleitenden Magnete bestehen im wesentlichen aus einer Magnetspule, die aus supraleitendem Draht gewickelt ist und sich in einem Kryostaten befindet, der die supraleitende Magnetspule auf der Betriebstemperatur von etwa 4 K hält.

Üblicherweise werden für die genannten Anwendungen Solenoidspulen verwendet, die sich in einem Behälter für flüssiges Helium befinden. Dieser Behälter ist von einem weiteren Behälter umgeben, der mit flüssigem Stickstoff gefüllt ist. Zwischen diesen Behältern und ggf. zwischen dem Stickstoffbehälter und der Außenhülle des Magnetsystems sind sog. Schutzschilde (heat shields) angeordnet, die auf einer jeweils zwischen den angrenzenden Temperaturen liegenden Temperatur gehalten werden und ebenfalls zur Vorkühlung des innersten, das flüssige Helium enthaltenden Behälters dienen.

Die supraleitende Spule wird mit einem Strom beaufschlagt und dann in an sich bekannter Weise kurz geschlossen, so daß der eingespeiste Strom in der supraleitenden Spule praktisch unendlich lange fließen kann, solange die Supraleitung aufrechterhalten wird.

Die Betriebskosten eines derartigen supraleitenden Magneten werden entscheidend durch den Verbrauch an den erwähnten flüssigen Gasen, nämlich flüssigem Stickstoff und flüssigem Helium bestimmt. Gelingt es dabei, die Abdampfrate dieser flüssigen Gase niedrig zu halten, können die Betriebskosten eines derartigen supraleitenden Magneten niedrig gehalten werden, so daß — zusätzlich zu den Magnetfeldeigenschaften — auch hinsichtlich der Betriebskosten wesentlich günstigere Verhältnisse als bei klassischen Einsenmagneten vorliegen.

Um die Abdampfrate der flüssigen Gase niedrig zu halten, ist es bekannt, an die Außenhüllte des supraleitenden Magnetsystems ein Kühlsystem anzubauen, das üblicherweise als Refrigerator bezeichnet wird. Diese bekannten Refrigeratoren verfügen über einen Kühlarm, der sich durch die Außenhülle des Kryostaten hindurch erstreckt und bis zu einem oder mehreren der Innenbehälter oder der Schutzschilde reicht und diese aktiv kühlt. Der Kühlarm bzw. der Kühlarm mit einem noch weiter vorspringenden Kühlfinger halten dabei die inneren Behälter bzw. Schutzschilde auf einer so niedrigen Temperatur, daß die Abdampfverluste der flüssigen Gase einen besonders niedrigen Wert erreichen.

Aus dem Aufsatz von Yamamoto in der Zeitschrift Review of Scientific Instruments, 50, Seite 1382 bis 1385, (1979) ist ein derartiges System bekannt, bei dem ein Refrigerator auf einen Kryostaten aufgesetzt ist und über zwei unterschiedlich lange Kühlarme innere Schutzschilde des Kryostaten aktiv kühlt. Der Refrigerator ist dabei fest mit dem Kryostaten verbunden.

Die bekannnen Refrigeratoren weisen einen außerhalb der Außenhülle des Magnetsystems angeordneten Kühlkopf auf, der einen motorischen Antrieb mit Kolben u. dgl. enthält. Dieser motorische Antrieb wird vorzugsweise mit Preßluft angetrieben, die von einem weiter entfernt stehenden Kompressor über eine flexible Leitung geliefert wird. Damit sind zwar die wersentlichen bewegten und Störungen verursachenden Teile weitab vom Magnetsystem angeordnet, trotzdem verbleibt im Kühlkopf noch eine Reihe motorisch angetriebener Elemente, die zu Störungen führen können. Der oder die im Kühlkopf angeordneten beweglichen Kolben wirken sich nämlich direkt auf das Magnetfeld aus, sei es dadurch, daß sie das supraleitende Magnetsystem in Vibration versetzen, sei es, daß durch die Bewegung der metallischen Kolben Störfelder induziert werden.

Supraleitende Magnetsysteme der weiter oben beschriebenen Art werden vorzugsweise zur Messung von magnetischen Resonanzen, beispielsweise der magnetischen Kernresonanz, verwendet. Bei hochauflösenden Messungen, die ein besonders homogenes Magnetfeld erfordern, wirken sich Störungen der genannten Art durch den motorischen Antrieb des Refrigerators besonders aus, weil der motorische Antrieb des Refrigerators bei verhältnismäßig tiefen Frequenzen arbeitet und die hierdurch verursachten Störungen durch die üblichen Stabilisierungsmaßnahmen nicht ausgeglichen werden können. Dies gilt auch für den sog. internen Lock, bei dem das Magnetfeld mit Hilfe einer Referenzlinie im Kernresonanz-Spektrum geregelt wird.

Wie bereits oben erwähnt, werden die genannten supraleitenden Magnetsysteme im « persistent mode » unter Umständen über Jahre hinweg in Betrieb gehalten. Dies ist deswegen möglich, weil die Aufrechterhaltung des Magnetfeldes in supraleitenden Magneten ein verlustfreier Vorgang ist, da Verluste aufgrund der Supraleitung nicht auftreten. Demgegenüber ist der Refrigerator bei den genannten Anordnungen mechanischem Verschleiß unterworfen, so daß eine derartig lange Betriebszeit bei den heute verfügbaren Refrigeratoren nicht möglich ist. Es ist demzufolge erforderlich, den Refrigerator in bestimmten Zeitabständen mechanisch zu

warten. Für eine derartige Wartung ist es jedoch erforderlich, den Refrigerator auf Raumtemperatur zu erwärmen, um beispielsweise O-Ringe oder andere Dichtungen austauschen zu können oder andere mechanische Teile zu ersetzen. Ein mechanischer Abbau eines fest mit dem Kryostaten verbundenen Refrigerators führt jedoch bei den bekannten Einrichtungen zu einer Betriebsunterbrechung, da der Refrigerator in die evakuierten Teile des Kryostaten hineinreicht und das Vakuum beim Abbau des Refrigerators folglich nicht aufrecht erhalten werden kann. Dann geht jedoch die supraleitende Spule infolge Erwärmung in den normalleitenden Zustand über, so daß insgesamt die maximal erreichbare Betriebsdauer im « persistent .mode » durch die mechanische Standzeit des Refrigerators begrenzt ist.

Der Erfindung liegt demgegenüber die Aufgabe zugrunde, eine Einrichtung zu schaffen, bei der einerseits besonders geringe Abdampfraten der flüssigen Gase durch Verwendung eines Refrigerators möglich sind, andererseits jedoch die geschilderten Nachteile infolge von durch den Refrigerator verursachten Störungen vermieden werden.

Diese Aufgabe wird erfindungsgemäß dadurch gelöst, daß eine Sensoreinrichtung zum Erfassen der vom motorischen Antrieb des Refrigerators ausgehenden magnetischen und/oder mechanischen Störsignale vorgesehen ist, die mindestens eine Korrekturspule zum Kompensieren des im Probenraum wirksamen, von dem Antrieb des Refrigerators verursachten Störfeldes steuert.

Die erfindungsgemäße Kühleinrichtung hat damit den besonderen Vorteil, daß sie den Einsatz von aktiv gekühlten Schutzschilden selbst bei hochauflösenden Kernresonanz-Messungen erlaubt.

Bei einer bevorzugten Ausführungsform der Erfindung umfaßt die Sensoreinrichtung eine im Bereich des Refrigerators angeordnete Detektorspule. Diese Anordnung hat den Vorteil, daß die Störsignale dort erfaßt werden, so sie erzeugt werden. Das von der Detektorspule aufgenommene Störsignal ist damit in dieser räumlichen Anordnung auch besonders groß.

Bei einer anderen, auch zusätzlich verwendbaren Ausführungsform der Erfindung ist eine Detektorspule im Bereich des Probenraumes des Magnetsystems angeordnet. Diese Anordnung hat den Vorteil, daß die Störsignale dort erfaßt werden, wo sie wirksam werden, so daß genau der Störanteil kompensiert werden kann, der auch zu Störungen der Messung führen würde.

Bei beiden genannten Anordnungen wird eine Ausführungsform bevorzugt, bei der die Störsignale in mehreren unterschiedlichen Gradientenrichtungen erfaßt werden. Dabei macht man sich zunutze, daß die Erfassung und Kompensation von Magnetfeldinhomogenitäten entlang vorgegebener Magnetfeldgradienten bekannt ist und eine Vielzahl von Regelalgorithmen zur Verfügung steht, um entsprechende Magnetfeldkorrekturen vorzunehmen.

Bei einer weiteren Ausführungsform der Erfindung, bei der der Refrigerator einen den motorischen Antrieb enthaltenden Kühlkopf aufweist, geht der Kühkopf in einen ersten Flansch über, der auf einem zweiten Flansch aufliegt, in den ein an die Außenhülle des Magnetsystems angeformter Hals übergeht. Die Detektorspule ist dabei vorzugsweise im Bereich des Halses angeordnet, insbesondere als ein den Hals koaxial umfassendes Solenoid. Diese Anordnung ergibt einen besonders kompakten und mechanisch stabilen Aufbau. Auch wird bei dieser Anordnung die Demontierbarkeit des Kühlkopfes, beispielsweise für Wartungsarbeiten, nicht beeinträchtigt.

Alternativ oder zusätzlich zu den vorstehend genannten Ausführungsformen, bei denen das vom Refrigerator ausgehende elektromagnetische Störfeld erfaßt wird, wird eine Sensoreinrichtung verwendet, die die vom Refrigerator ausgehenden mechanischen Störungen erfaßt, insbesondere durch Messung der Beschleunigung oder der Vibration an einer geeigneten Stelle entweder am Refrigerator selbst oder an einer anderen Stelle des Magnetsystems. Diese Vorgehensweise hat den zusätzlichen Vorteil, daß auch die mechanischen Störungen bei unmagnetischen oder nichtmetallischen Elementen des Magnetsystems erfaßt werden können, die sich nicht in elektromagnetisch meßbaren Störungen manifestieren, ebenso wie solche, die am Ort der Detektorspule kaum Sörsignale erzeugen, als mechanische Signale jedoch meßbar sind.

Eine besonders gute Wirkung wird erzielt, wenn ein elektronisches Steuergerät vorgesehen ist, das das Ausgangssignal der Sensoreinrichtung der zu Kompensationszwecken dienenden Korrekturspule zuführt. Dann kann nämlich das Sensorsignal entsprechend gewichtet werden, beispielsweise durch Herunterteilen oder Multiplizieren, je nachdem welches Verhältnis zwischen dem gemessenen Störsignal und dem einzustellenden Kompensationssignal besteht. Besonders bevorzugt ist dabei eine Ausführungsform, bei der das Sensorsignal über eine Kennlinie oder ein Kennfeld geleitet wird, weil damit einmal auch nichtlineare Abhängigkeiten berücksichtigt werden können und andererseits auch veränderte Meßparameter ihren Niederschlag finden können. Diese Meßparameter können beispielsweise die Grundfeldstärke, eine eingestrahle Modulation, eine Probentemperatur o. dgl. sein.

Zur Kompensation des vom Refrigerator ausgehenden Störfeldes kann eine Korrekturspule an unterschiedlichen Stellen des Magnetsystemes angeordnet sein, sofern sie nur im Probenraum wirksam wird. Besonders bevorzugt ist dabei eine Anordnung, bei der die Korrekturspule den probenraum unmittelbar umgibt. Damit werden die vom Refrigerator ausgehenden Störungen an der Stelle kompensiert, an der sie wirksam werden.

Alternativ oder zusätzlich ist es aber auch möglich, die Korrekturspule im Bereich des Refrigerators selbst anzuordnen, so daß die Störungen an der Stelle kompensiert werden, wo sie entstehen, so daß die Störungen gar nicht mehr auf das Magnetsystem übertragen werden oder wenn, dann nur noch in stark abgeschwächter Form.

Ausgehend von dieser letztgenannten Überlegung wird eine Anordnung besonders bevorzugt, bei der eine Grobkompensation über die im Bereich des Refrigerators angeordnete Korrekturspule und in einem nachfolgenden zweiten Schritt eine Feinkompensation durch die im Bereich des Probenraumes angeordnete Korrekturspule vorgenommen wird. Diese zweistufige Kompensation führt zu einem besonders effektiven Ergebnis.

Eine besonders gute Kompensation ist dann möglich, wenn mehrere Korrekturspulen in unterschiedlicher Gradientenrichtung angeordnet sind, so daß — wie bereits weiter oben angedeutet wurde — eine Gradientenkompensation nach einem der an sich bekannten Verfahren vorgenommen werden kann.

Eine weitere Ausbildung der Erfindung zeichnet sich dadurch aus, daß die Durchführung durch die Außenhülle als vakuumdichte Schiebevorrichtung ausgebildet ist.

Diese erfindungsgemäße Kühleinrichtung hat damit den besonderen Vorteil, daß die Supraleitung in der Magnetspule aufrecht erhalten werden kann, während der Refrigerator mechanisch gewartet wird. Dies wird dadurch erreicht, daß das Vakuum im Kryostaten aufrecht erhalten bleibt, so daß die Magnetspule durchgehend auf der erforderlichen Betriebstemperatur von 4K gehalten werden kann. Damit vereint die erfindungsgemäße Kühleinrichtung die Vorteile einer niedrigen Abdampfrate bei eingeschaltetem Refrigerator mit den Vorteilen einer langen Betriebsdauer des supraleitenden Magnetsystems im « persistent mode ».

In bevorzugter Ausgestaltung der Erfindung ist der Kühlarm dabei in einem zum Refrigerator gehörigen Rohr angeordnet, das in einem an die Außenhülle angeformten Hals verschiebbar ist. Eine derartige Anordnung ist deshalb besonders vorteilhaft, weil zwischem dem Hals und dem Rohr eine Dichtung wirksam werden kann, beispielsweise ein O-Ring und/oder ein Faltenbalg, Dichtelemente, die ausgereift erhältlich sind und eine gute Vakuumdichtung ermöglichen.

In besonders bevorzugter Ausgestaltung der Erfindung läuft der Kühlarm in einen Endabschnitt und von dort in einen gegenüber dem Endabschnitt verjüngten Finger aus, wobei Endabschnitt und Finger im eingeschobenen Zustand des Refrigerators in mechanischer Verbindung mit zwei hintereinanderliegenden Zwischenschilden stehen. Bringt man den Endabschnitt bzw. den Finger auf unterschiedliche Temperaturen, kann man mit dieser Anordnung, die besonders leicht justier- und einführbar ist, zwei hintereinanderliegende, auf unterschiedlicher Temperatur liegende Schutzschild bzw. Innenbehälter mit dem Refrigerator kühlen.

Um die zur mechanischen Wartung des Refrigerators im ausgefahrenen Zustand erforderliche Zeit zu vermindern, die ja die während der Wartungszeit erhöhten Abdampfverluste der flüssigen Gase bestimmt, ist in weiterer Ausgestaltung der Erfindung im Kühlarm eine Heizeinrichtung vorgesehen, mit der es möglich ist, den Kühlarm bzw. den Refrigerator schneller auf eine Temperatur zu bringen, bei der die mechanische Wartung, etwa das Auswechseln der Dichtungselemente, möglich ist.

Weitere Vorteile ergeben sich aus der Beschreibung und der beigefügten Zeichnung.

Die Erfindung ist in der Zeichnung dargestellt und wird in der nachfolgenden Beschreibung näher erläutert. Es zeigen

Figur 1 einen Querschnitt durch eine Hälfte eines Kryostaten, der mit einem Ausführungsbeispiel einer erfindungsgemäßen Kühleinrichtung versehen ist ;

Figur 2 eine vergrößerte Ansicht eines Ausschnittes aus Fig. 1 ;

Figur 3 einen Querschnitt durch eine Hälfte eines Kryostaten, der mit einem weiteren Aus- ' führungsbeispiel einer erfindungsgemäßen Kühleinrichtung versehen ist ;

Figur 4 eine vergrößerte Ansicht eines Ausschnittes aus Fig. 3 ;

Figuren 5a, 5b ein bevorzugtes Ausführungsbeispiel eines Kopplungsteiles, wie es bei den Anordnungen gemäß Fig. 3 und 4 verwendet werden kann.

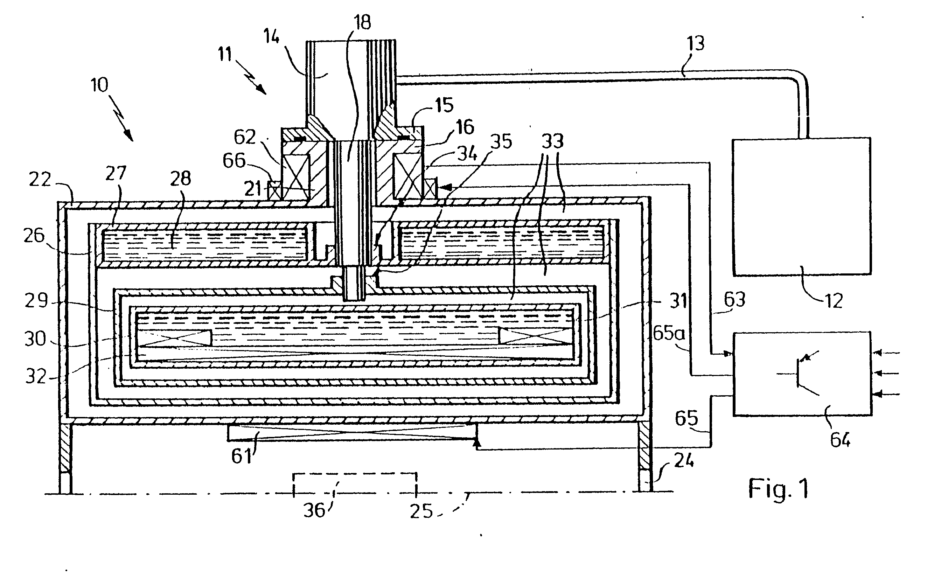

In Fig. 1 bezeichnet 10 ein supraleitendes Magnetsystem, das über einen Refrigerator 11 zum Kühlen von innenliegenden Schutzschilden bzw. Behältern verfügt. Der Refrigerator 11 wird von einem räumlich getrennten Kompressor 12 über eine flexible Druckleitung 13 beispielsweise mit Hochdruckgas versorgt. Der Refrigerator 11 ist als Aufsatz ausgebildet, der aus einem Kühlkopf 14 sowie einem daran angeformten ersten Flansch 15 besteht. Der erste Flansch 15 liegt auf einem zweiten Flansch 16 auf, der in einen Hals 21 übergeht, der einen vom Refrigerator 11 sich erstreckenden Kühlarm 18 umschließt. Der Hals 21 ist an einer Außenhülle 22 des supraleitenden Magnetsystems 10 angeformt.

Die Außenhülle 22 geht an den Endabschnitten des supraleitenden Magnetsystems 10 in Deckenteile über, in denen sich auch eine Probenöffnung 24 in der Achse 25 des Magnetsystems 10 befindet. Es versteht sich, daß die Darstellung in Fig. 10 nur eine Hälfte des im wesentlichen rotationssymmetrisch ausgebildeten Magnetsystems 10 darstellt.

Die Außenhülle 22 umgibt zunächst einen ersten Zwischenschild 26, der in unmittelbarem mechanischen und damit wärmeleitenden Kontakt zu einem Behälter 27 steht, der flüssigen Stickstoff 28 enthält. Der erste Zwischenschild 26 umgibt einen zweiten Zwischenschild 29, der mit keinem Behälter für ein flüssiges Gas verbunden ist. Der zweite Zwischenschild 29 umgibt wiederum einen Behälter 30 für flüssiges Helium 31. Im Behälter 30 bzw. im flüssigen Helium 31 befindet sich eine Magnetspule 32, im dargestellten Ausführungsbeispiel ein Solenoid. Die Zwischenräume 33 zwischen der Außenhülle 22, dem ersten Zwischenschild 26, dem zweiten Zwischenschild 29 sowie dem Behälter 30 sind dabei evakuiert.

In Fig. 1 sind die bekannten Befestigungsmittel und Isolationsfolien (Superisolation) für die einzelnen Behälter des Magnetsystems 10 nicht dargestellt.

Im Inneren der Probenöffnung 24 ist mit 36 ein Probenraum bezeichnet, in den die mit dem Magnetsystem 10 auszumessende Probe gebracht wird, beispielsweise eine Probe, an der hochauflösende Kernresonanz (NMR)-Messungen durchgeführt werden sollen.

Um den Wärmeübergang zwischen dem Kühlarm 18 des Refrigerators 11 und dem von diesem zu kühlenden ersten Zwischenschild 26 bzw. zweiten Zwischenschild 29 herzustellen, sind den Schilden 26, 29 Kopplungsteile 34, 35 vorgesehen.

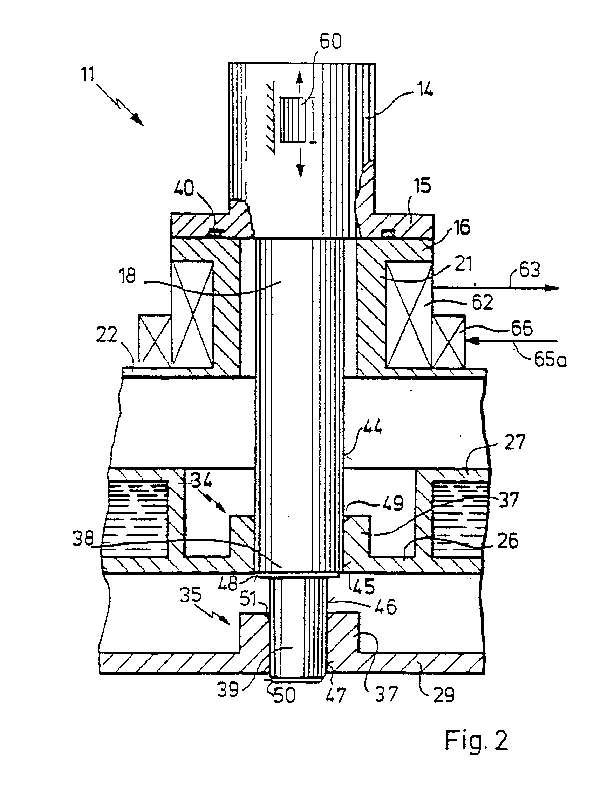

Betrachtet man nun die vergrößerte Darstellung des Refrigerators 11 mit den zugehörigen Teilen des Magnetsystems 10 in Fig. 2, so erkennt man, daß der Kühlarm 18 an seinem der Magnetspule 30 zugewandten Ende zunächst in einen Endabschnitt 38 und dann in einen konzentrischen Finger 39 mit gegenüber dem Endabschnitt 38 vermindertem Querschnitt ausläuft.

Der Kühlkopf 14 des Refrigerators 11 ist mit einem ersten Flansch 15 versehen, der auf dem zweiten Flansch 16 des Halses 21 aufliegt. Um eine besonders gute Dichtung zwischen den Flanschen 15, 16 herzustellen, ist zwischen diesen eine als O-Ring 40 ausgebildete Dichtung vorgesehen.

Der Endabschnitt 38 ist in wärmeleitendem Kontakt mit dem Kopplungsteil 34 und der Finger 39 in wärmeleitendem Kontakt mit dem Kopplungsteil 35. Hierzu sind die Kopplungsteile 34 bzw. 35 als zylinderartige Vorsprünge 37 der Schilde 26 bzw. 29 ausgebildet, durch die zentrale Bohrungen führen. Der Außendurchmesser 44 bzw. 46 von Endabschnitt 38 bzw. Finger 39 sowie die Innendurchmesser 45 bzw. 47 der genannten Vorsprünge 37 sind dabei so bemessen, daß sich eine gute mechanische Passung und damit ein guter Wärmeübergang zwischen den genannten Teilen ergibt. Der Endabschnitt 38 wird dann vom Refrigerator 11 auf die Temperatur gebracht, die der erste Zwischenschild 26 annehmen soll, beispielsweise 80 bis 100 K, während der Finger 39 auf die Temperatur abgekühlt wird, die der zweite Zwischenschild 29 annehmen soll, beispielsweise 20 bis 50 K.

Um das Einführen von Endabschnitt 38 bzw. Finger 39 in die Kopplungsteile 34 bzw. 35 zu erleichtern, sind die jeweiligen Stirnflächen von Endabschnitt 38 bzw. Finger 39 mit Fasen 48 bzw. 50 versehen, ebenso wie die nach außen weisenden Stirnflächen der Vorsprünge 37 mit Fasen 49 bzw. 51 versehen sind.

Die verwendeten Materialien, insbesondere die für die Kopplungsteile 34, 35 sind so gewählt, daß sie bei tiefen Temperaturen eine besonders gute Wärmeleitung aufweisen.

Im Kühlkopf 14 des Refrigerators 11 befindet sich ein motorischer Antrieb, wie er durch einen beweglichen Kolben 60 in Fig. 2 angedeutet ist. Neben dem Kolben 60 befinden sich selbstverständlich noch weitere bewegliche Teile im Kühlkopf 14, beispielsweise Pleuel, Achsen u. dgl. Diese mechanisch bewegten Teile des motorischen Antriebes wirken sich in zweierlei Hinsicht störend auf den Betrieb des Magnetsystems 10 aus. Zum einen induzieren bewegte metallische Teile unmittelbar ein magnetisches Feld, zum anderen wirkt sich die Bewegung der massebehafteten Teile als Vibration auf das Magnetsystem 10 aus. Dies ist in dem hier vorliegenden Falle besonders kritisch, weil sich unmittelbar vom Kühlkopf 14 hinweg der Kühlarm 18 erstreckt, der eine feste mechanische Kopplung über den Endabschnitt 38 mit dem Kopplungsteil 34 bzw. den Finger 39 mit dem Kopplungsteil 35 zu den Zwischenschilden 26, 29 in unmittelarer Nähe der Magnetspule besitzt. Im Bereich des Kühlkopfes 14 entstehende Vibrationen pflanzen sich damit unmittelbar in die direkte nähe der Magnetspule 30 fort.

Zur Kompensation dieser Störungen ist eine Korrekturspule 61 in der Probenöffnung 24 vorgesehen, die den Probenraum 36 umschließt. Das Speisesignal für die Korrekturspule 61 wird von einer Detektorspule 62 abgeleitet, die in dem in den Figuren dargestellten Ausführungsbeispiel eine Solenoidspule ist, die den Hals 21 umgibt. Das Ausgangssignal der Detektorspule 62 wird über eine Leitung 63 einem elektronischen Steuergerät 64 zugeführt, das über eine Leitung 65 die Korrekturspule 61 speist. Beispielsweise kann das elektronische Steuergerät 64 das Signal der Detektorspule 62 verstärken oder mit einem vorbestimmten Faktor abschwächen, d. h. insgesamt gewichten, wenn eine derartige lineare Beziehung von gemessenem Signal zu Korrektursignal ausreicht. Es ist jedoch selbstverständlich auch möglich, im Falle einer nichtlinearen Abhängigkeit im Steuergerät 64 eine Kennlinie oder ein Kennfeld vorzusehen, je nachdem, ob ein oder mehrere bestimmende Einflußfaktoren berücksichtigt werden. Bei Verwendung eines Kennfeldes können auch weitere Parameter dem Steuergerät 64 zugeführt werden, beispielsweise die eingestellte Grundfeldstärke, eingestrahlte Modulationsfrequenzen, eine Probentemperatur o. dgl.

In jedem Falle wird das von der Detektorspule 62 erfaßte Signal entsprechend einer vorgegebenen Beziehung in ein Korrektursignal umgesetzt und mit diesem Korrektursignal die Korrekturspule 61 beaufschlagt.

Während die vorstehend beschriebene Anordnung über die Detektorspule 62 die Störung durch den Refrigerator 11 an der Stelle erfaßt, an der sie erzeugt wird, kann diese Störung natürlich auch an jedem anderen geeigneten Ort erfaßt werden, insbesondere am Probenort 36.

Ebenso kann die Korrektur des Störfeldes nicht nur, wie in Fig. 1 dargestellt, am Probenort 36 über die Korrekturspule 61 erfolgen, es ist vielmehr auch vorgesehen, die Störung an der Stelle zu kompensieren, an der sie erzeugt wird. Hierzu ist laut Ausführungsbeispiel gemäß Fig. 2 koaxial um die Detektorspule 62 eine weitere Korrekturspule 66 angeordnet, die vom elektronischen Steuergerät 64 über eine Leitung 65a angesteuert wird. Für das der weiteren Korrekturspule 66 zugeführte Signal gelten dieselben Überlegungen, wier sie weiter oben zur Korrekturspule 61 angestellt wurden. Das heißt, daß die Korrekturspule 66 in Abhängigkeit von einem vom Steuergerät 64 gebildeten Korrektursignal angesteuert wird, das aus dem von irgendeiner Detektorspule, beispielsweise der Detektorspule 62, abgegebenen Signal abgeleitet wird.

Besonders bevorzugt ist dabei eine Ausführungsform, bei der eine Grobkompensation über die Leitung 65a und die weitere Korrekturspule 66 im Bereich des Refrigerators 11 vorgenommen wird und nachfolgend in einem zweiten Schritt eine Feinkompensation über die Korrekturspule 61 im Bereich des Probenortes 36 erfolgt.

Da die vom Refrigerator 11 ausgehenden Störungen sich nicht nur in einer einzigen Richtung ausbreiten, sondern vielmehr einen beliebigen Störrfeldverlauf aufweisen, ist vorgesehen, die Detektor- und/oder Korrekturspulen jeweils mehrfach und örtlich verteilt vorzusehen, wobei die Einzelspulen der dann entstehenden Anordnungen in definierten Gradientenrichtungen wirksam sind. Derartige Mehrfachspulenanordnungen sind an sich bekannt und werden üblicherweise als « Shimspulen » bezeichnet, wobei jede einzelne bzw. jedes Paar derartiger Shimspulen zur Kompensation eines der bekannten Magnetfeldgradienten vorgesehen ist.

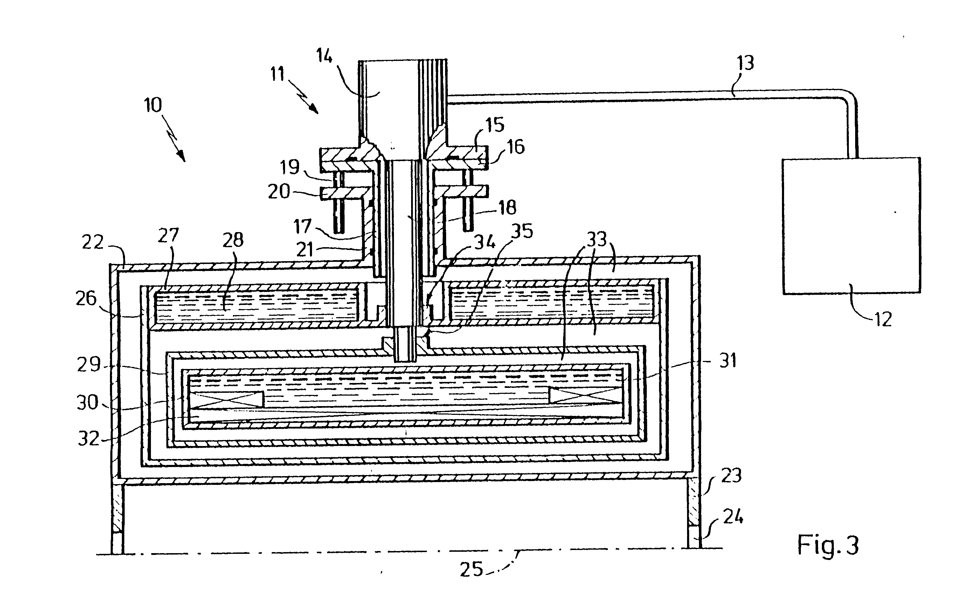

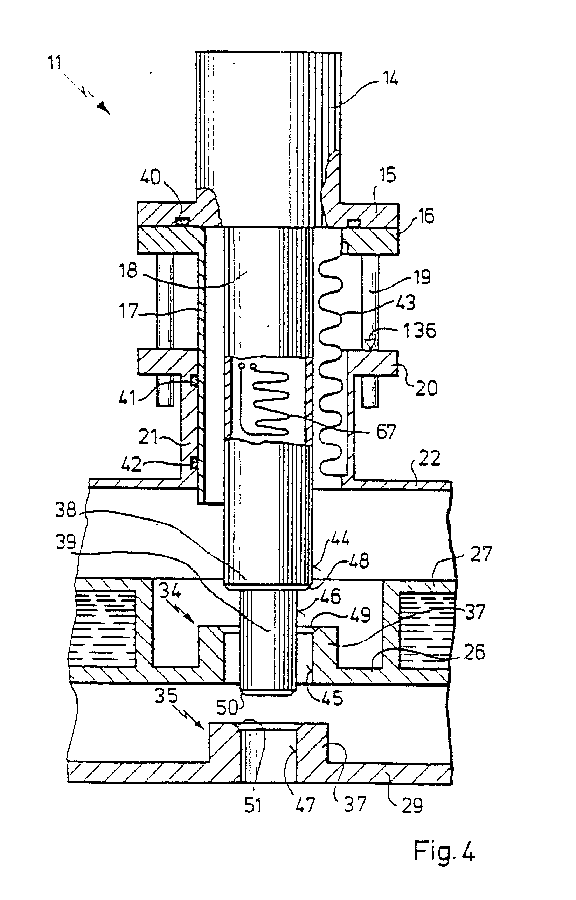

In Fig. 3 und 4 ist der Refrigerator 11 als Aufsatz ausgebildet, der aus dem Kopf 14 sowie dem daran angeformten ersten Flansch 15 besteht. Der erste Flansch 15 liegt auf dem zweiten Flansch 16 auf, der in ein Rohr 17 übergeht, das den vom Refrigerator 11 sich erstreckenden Kühlarm 18 umschließt. Im zweiten Flansch 16 sind als Abstandshalter 19 dienende Stangen angeordnet, die in einem gegenüber dem zweiten Flansch 16 liegenden dritten Flansch 20 laufen. Selbstverständlich ist es jedoch auch möglich, die Abstandshalter 19 im dritten Flansch 20 zu befestigen und im ersten bzw. zweiten Flansch 15, 16 laufen zu lassen. Der dritte Flansch 20 ist dabei Teil eines Halses 21, der an einer Außenhülle 22 des supraleitenden Magnetsystems 10 angeformt ist.

Die Außenhülle 22 geht an den Endabschnitten des supraleitenden Magnetsystems 10 in Deckenteile 23 über, in denen sich auch die Probenöffnung 24 in der Achse 25 des Magnetsystems 10 befindet. Es versteht sich, daß auch die Darstellung in Fig. 3 nur eine Hälfte des Magnetsystems 10 darstellt.

Die Dichtwirkung zwischen dem verschiebbaren Refrigerator 11 und dem Kryostaten kann entweder über O-Ringe 41, 42, die zwischen dem Hals 21 und dem Rohr 17 angeordnet sind, hergestellt werden und/oder über einen Faltenbalg 43 zwischen Hals 21 bzw. Flansch 20 erreicht werden. In Fig. 4 handelt es sich um eine vereinfachte Darstellung, in der zwei Ausführungsformen in einer Skizze gezeigt werden. Die tatsächlichen Ausführungsformen sind i. a. rotationssymmetrisch.

Bei der Darstellung gemäß Fig. 4 ist der Refrigerator 11 im ausgefahrenen Zustand dargestellt. Zum Ausfahren des Refrigerators 11 gleitet das Rohr 17 im Hals 21 von der eingefahrenen Stellung, bei der der zweite Flansch 16 auf dem dritten Flansch 20 aufliegt bis in die dargestelle ausgefahrene Stellung, die dadurch gekennzeichnet werden kann, daß auf einem der Abstandshalter 19 eine Marke 136 angebracht ist, die den ausgefahrenen Zustand des Refrigerators 11 anzeigt.

In diesem ausgefahrenen Zustand des Refrigerators 11 kann zunächst über Heizeinrichtung 67 der Kühlarm 18 auf Raumtemperatur gebracht werden, damit ein Austausch mechanischer Teile, beispielsweise von Dichtelementen, möglich ist. Die Heizeinrichtung 67 ist dabei, wie aus Fig. 4 ersichtlich ist, in einem Bereich angeordnet, der im ausgefahrenen Zustand des Refrigerators 11 außerhalb der Außenhülle 22 liegt, so daß die Rückwirkung dieser Aufheizung auf die innenliegenden Teile, insbesondere die Schutzschilde 26 und 29 minimal bleibt.

Im ausgefahrenen Zustand des Refrigerators 11 bleibt jedoch die Vakuumdichtwirkung voll erhalten, so daß keine Beeinträchtigung des Vakuums in den Zwischenräumen 33 eintritt und demnach die Magnetspule 32 im supraleitenden Zustand verbleiben kann.

Sind die mechanischen Wartungsarbeiten am Refrigerator 11 beendet, kann dieser aus der Fig. 4 eingezeichneten Stellung wieder in seine Arbeitsstellung eingeschoben werden.

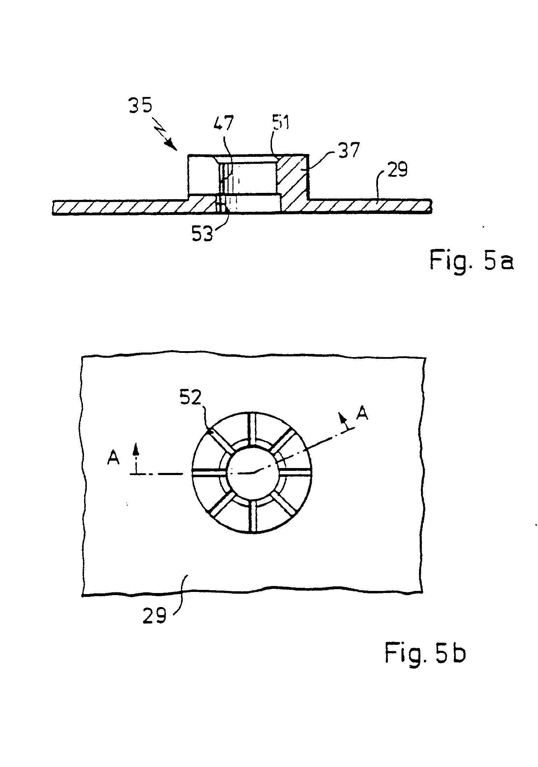

In Fig. 5 ist eine Ausführungsform des Kopplungsteils 35 abgebildet, wobei Fig. 5a eine Schnittdarstellung ist, die dem Schnitt entlang der Linie AA in Fig. 5b entspricht. Der Vorsprung 37 ist dabei mit der bereits erwähnten zentralen Bohrung des Innendurchmessers 47 versehen, von der radiale Schlitze 52 durch den Vorsprung 37 hindurchgehen. Verjüngt man weiterhin das Fußteil des stehenbleibendes Restes des Vorsprunges 37 durch eine Ansenkung mit einem Durchmesser 53, der größer als der Durchmesser 47 ist, entsteht eine federnde, kronenartige Halterung, in die der Finger 39 federnd eingeführt werden kann. Durch die federnde Halterung des Fingers 39 entsteht dabei eine kraftschlüssige Verbindung zwischen Vorsprung 37 und Finger 39, die einen besonders gut wärmeleitenden Übergang bewirkt.

**Patentansprüche**

1. Kühleinrichtung für ein Tieftemperatur-Magnetsystem, bei dem eine einen Probenraum (36) umschließende Magnetspule (32) von wenigstens einem Zwischenschild (26, 29) umgeben in einer evakuierten Außenhülle (22) gehalten ist und ferner ein auf der Außenhülle (22) angeordneter, motorisch angetriebener Refrigerator (11) vorgesehen ist, der über einen durch die Außenhülle (22) führenden Kühlarm (18) das/die Zwischenschild(e) (26, 29) kühlt, dadurch gekennzeichnet, daß eine Sensoreinrichtung zum Erfassen der vom motorischen Antrieb des Refrigerators (11) ausgehenden magnetischen und/oder mechanischen Störsignale vorgesehen ist, die mindestens eine Korrekturspule (61, 66) zum Kompensieren des im Probenraum (36) wirksamen, von dem Antrieb des Refrigerators (11) verursachten Störfeldes steuert.

2. Kühleinrichtung nach Anspruch 1, dadurch gekennzeichnet, daß die Sensoreinrichtung mindestens eine im Bereich des Refrigerators (11) angeordnete Detektorspule (62) umfaßt.

3. Kühleinrichtung nach Anspruch 1 oder 2, dadurch gekennzeichnet, daß die Sensoreinrichtung mindestens eine im Bereich des Probenraumes (36) angeordnete Detektorspule umfaßt.

4. Kühleinrichtung nach Anspruch 2 oder 3, dadurch gekennzeichnet, daß mehrere, in unterschiedlicher Gradientenrichtung wirksame Detektorspulen vorgesehn sind.

5. Kühleinrichtung nach einem der Ansprüche 2 oder 4, dadurch gekennzeichnet, daß der Refrigerator (11) einen den motorischen Antrieb enthaltenden Kühlkopf (14) aufweist, der in einen ersten Flansch (15) übergeht, daß an die Außenhülle (22) ein in einen zweiten Flansch (16) übergehender Hals (21) angeformt ist, daß die Flansche (15, 16) im Betrieb des Refrigerators (11) aufeinanderliegen und daß eine Detektorspule (62) im Bereich des Halses (21) angeordnet ist.

6. Kühleinrichtung nach Anspruch 5, dadurch gekennzeichnet, daß die Detektorspule (62) ein den Hals (21) axial umfassendes Solenoid ist.

7. Kühleinrichtung nach einem der Ansprüche 1 bis 6, dadurch gekennzeichnet, daß die Sensoreinrichtung einen im Bereich des Refrigerators (11) angeordneten Beschleunigungs- oder Vibrationsaufnehmer umfaßt.

8. Kühleinrichtung nach einem der Ansprüche 1 bis 7, dadurch gekennzeichnet, daß das Ausgangssignal der Sensoreinrichtung über ein elektronisches Steuergerät (64) der Korrekturspule (61, 66) zugeführt wird.

9. Kühleinrichtung nach Anspruch 8, dadurch gekennzeichnet, daß das Steuergerät (64) das Ausgangssignal wichtet.

10. Kühleinrichtung nach Anspruch 8, dadurch gekennzeichnet, daß das Steuergerät (64) eine Kennlinie oder ein Kennfeld zum Umsetzen des Sensorsignales in ein Ausgangssignal für die Korrekturspule (61, 66) enthält.

11. Kühleinrichtung nach einem der Ansprüche 1 bis 10, dadurch gekennzeichnet, daß die Korrekturspule (62) im Bereich des Probenraumes (36) oder in Bereich des Refrigerators (11) ausgebildet ist.

12. Kühleinrichtung nach einem der Ansprüche 1-10, dadurch gekennzeichnet, daß je eine Korrekturspule (66) im Bereich des Probenraumes (36) und des Refrigerators (11) ausgebildet ist.

13. Kühleinrichtung nach Anspruch 6 und 11 oder 12, dadurch gekennzeichnet, daß die Korrekturspule (66) und die als Solenoid ausgebildete Detektorspule (62) koaxial angeordnet sind.

14. Kühleinrichtung nach Anspruch 11 oder 12, dadurch gekennzeichnet, daß mehrere, in unterschiedlicher Gradientenrichtung wirksame Korrekturspulen vorgesehen sind.

15. Kühleinrichtung nach einem der Ansprüche 10 bis 14, dadurch gekennzeichnet, daß bei Verwendung mindestens je einer Korrekturspule (62, 66) im Bereich des Refrigerators (11) und des Probenraumes (36) das Steuergerät (64) in einem ersten Schritt die Korrekturspule (66) im Bereich des Refrigerators (11) und nachfolgend in einem zweiten Schritt die Korrekturspule (62) im Bereich des Probenraumes (36) ansteuert.

16. Kühleinrichtung nach Anspruch 1, dadurch gekennzeichnet, daß die Durchführung durch die Außenhülle (22) als vakuumdichte Schiebevorrichtung ausgebildet ist.

17. Kühleinrichtung nach Anspruch 16, dadurch gekennzeichnet, daß der Kühlarm (18) in einem zum Refrigerator (11) gehörigen Rohr (17) angeordnet ist, das in einem an die Außenhülle (22) angeformten Hals (21) verschiebbar ist.

18. Kühleinrichtung nach Anspruch 16, dadurch gekennzeichnet, daß der Kühlarm (18) an seinem der Magnetspule 30 zugewandten Ende zunächst in einen Endabschnitt 38 und dann in einen konzentrischen Finger 39 mit gegenüber dem Endabschnitt 38 vermindertem Querschnitt ausläuft und daß der Endabschnitt (38) und der verjüngte Finger (39) im eingeschobenen Zustand des Refrigerators (11) in mechanischer Verbindung mit wenigstens zwei hintereinanderliegenden Zwischenschilden (26, 29) stehen.

19. Kühleinrichtung nach Anspruch 16, dadurch gekennzeichnet, daß der Kühlarm (18) über eine Heizeinrichtung (67) verfügt.

**Claims**

1. Cooling device for a low-temperature magnet system in which a magnetic coil (32), enclosing a sample space (36), is held surrounded by at least one intermediate shield (26, 29) in an evacuated outer casing (22) and also a motor-driven refrigerator (11) is provided which is arranged on the outer casing (22) and which cools the intermediate shield(s) (16, 29) via a cooling arm (18) leading through the outer casing (22), characterized in that a sensor device for detecting the magnetic and/or mechanical interference signals emanating from the motor drive of the refrigerator (11) is provided, which sensor device controls at least one correction coil (61, 66) for compensating the interference field which is caused by the drive of the refrigerator (11) and which is effective in the sample space (36).

2. Cooling device according to Claim 1, characterized in that the sensor device comprises at least one detector coil (62) arranged in the area of the refrigerator (11).

3. Cooling device according to Claim 1 or 2, characterized in that the sensor device comprises at least one detector coil arranged in the area of the specimen space (36).

4. Cooling device according to Claim 2 or 3, characterized in that several detector coils are provided which are effective in a different gradient direction.

5. Cooling device according to one of Claims 2 or 4, characterized in that the refrigerator (11) has a cooling head (14) which contains the motor drive and which merges into a first flange (15), that a neck (21) merging into a second flange (16) is formed integrally with the outer casing (22), that the flanges (15, 16) rest on top of each other during the operation of the refrigerator (11) and that a detector coil (62) is arranged in the area of the neck (21).

6. Cooling device according to Claim 5, characterized in that the detector coil (62) is a solenoid which axially encloses the neck (21).

7. Cooling device according to one of Claims 1 to 6, characterized in that the sensor device comprises an acceleration or vibration pickup arranged in the area of the refrigerator (11).

8. Cooling device according to one of Claims 1 to 7, characterized in that the output signal of the sensor device is supplied to the correction coil (61, 66) via an electronic control unit (64).

9. Cooling device according to Claim 8, characterized in that the control unit (64) applies weighting to the output signal.

10. Cooling device according to Claim 8, characterized in that the control unit (64) contains a characterized in that the control unit (64) contains a characteristic curve or set of characteristic curves for converting the sensor signal into an output signal for the correction coil (61, 66).

11. Cooling device according to one of Claims 1 to 10, characterized in that the correction coil (62) is constructed in the area of the specimen space (36) or in the area of the refrigerator (11).

12. Cooling device according to one of Claims 1 to 10, characterized in that one correction coil (66) each is constructed in the area of the specimen space (36) and of the refrigerator (11).

13. Cooling device according to Claim 6 and 11 or 12, characterized in that the correction coil (66) and the detector coil (62) constructed as solenoids are coaxially arranged.

14. Cooling device according to Claim 11 or 12, characterized in that several correction coils are provided which are effective in different gradient directions.

15. Cooling device according to one of Claims 10 to 14, characterized in that if at least one correction coil (62, 66) each is used in the area of the refrigerator (11) and of the specimen space (36), the control unit (64) drives the correction coil (66) in the area of the refrigerator (11) in a first step and subsequently drives the correction coil (62) in the area of the specimen space (36) in a second step.

16. Cooling device according to Claim 1, characterized in that the lead-through through the outer casing (22) is constructed as a vacuum-tight sliding device.

17. Cooling device according to Claim 16, characterized in that the cooling arm (18) is arranged in a tube (17) associated with the refrigerator (11), which tube can be displaced in a neck (21) formed integrally with the outer casing (22).

18. Cooling device according to Claim 16, characterized in that the cooling arm (18), at its end facing the magnetic coil (30), first extends into an end section 38 and then into a concentric finger (39) having a cross section which is reduced compared with the end section (38), and that the end section (38) and the reduced finger (39) are mechanically joined to at least two intermediate shields (26, 29), located behind each other, when the refrigerator (11) is inserted.

19. Cooling device according to Claim 16, characterized in that the cooling arm (18) is provided with a heating device (67).

**Revendications**

1. Dispositif de refroidissement pour un système magnétique à basse température comportant une bobine magnétique (32) entourant un espace pour échantillon (36), la bobine étant maintenue à l'intérieur d'une enveloppe externe (22) sous vide, au moins un panneau intermédiaire (26, 29) étant disposé entre l'enveloppe et la bobine ainsi qu'un réfrigérateur (11) fonctionnant avec un moteur et qui refroidit le ou les panneau(x) intermédiaire(s) (26, 29) par un bras réfrigérant (18) traversant l'enveloppe extérieure (22), caractérisé en ce que :

un dispositif palpeur est prévu pour saisir les signaux parasites magnétiques et/ou mécaniques provenant de l'entraînement moteur du réfrigérateur (11), dispositif qui commande au moins une bobine correctrice (61, 66), pour compenser le champ de perturbations causées par le fonctionnement du réfrigérateur, agissant dans l'espace pour échantillon (36).

2. Dispositif de refroidissement selon la revendication 1, caractérisé en ce que le dispositif palpeur comprend au moins une bobine détectrice (62) disposée dans la zone du réfrigérateur.

3. Dispositif de refroidissement selon la revendication 1 ou 2, caractérisé en ce que le dispositif palpeur comprend au moins une bobine détectrice disposée dans l'espace pour échantillon (36).

4. Dispositif de refroidissement selon la revendication 2 ou 3, caractérisé en ce que sont prévues plusieurs bobines détectrices agissant dans une direction de gradient différente.

5. Dispositif de refroidissement selon l'une des revendications 2 ou 4, caractérisé en ce que :

le réfrigérateur (11) présente une tête froide (14) contenant l'entraînement moteur, avec un rebord sous forme d'un premier flanc (15),

à la forme de l'enveloppe extérieure est adapté un collier (21), avec un rebord sous forme d'un second flanc (16),

les flancs (15, 16) se superposent pendant le fonctionnement du réfrigérateur et,

une bobine (62) détectrice est disposée dans la zone du collier (21).

6. Dispositif de refroidissement selon la revendication 5, caractérisé en ce que la bobine détectrice (62) est un solénoïde entourant axialement le collier (21).

7. Dispositif de refroidissement selon l'une des revendications 1 à 6, caractérisé en ce que le dispositif palpeur comprend un absorbeur d'accélération ou de vibration disposés dans la zone du réfrigérateur (11).

8. Dispositif de refroidissement selon l'une des revendications 1 à 7, caractérisé en ce que le signal de départ du dispositif palpeur est transmis à la bobine correctrice (61, 66) par un instrument de commande électronique (64).

9. Dispositif de refroidissement selon la revendication 8, caractérisé en ce que l'instrument de commande (64) module le signal de départ.

10. Dispositif de refroidissement selon la revendication 8, caractérisé en ce que l'instrument de commande (64) contient une ligne de reconnaissance ou un champ de reconnaissance pour la transposition du signal palpeur en un signal de départ pour la bobine correctrice (61, 66).

11. Dispositif de refroidissement selon l'une des revendications 1 à 10, caractérisé en ce que la bobine correctrice (62) est installée dans la zone de l'espace pour échantillon (36) ou dans la zone du réfrigérateur (11).

12. Dispositif de refroidissement selon l'une des revendications 1 à 10, caractérisé en ce que chaque bobine correctrice (66) est installée dans la zone de l'espace pour échantillon (36) et du réfrigérateur (11).

13. Dispositif de refroidissement selon l'une des revendications 6, 11 et 12, caractérisé en ce que la bobine correctrice (66) et la bobine détectrice montée comme un solénoïde sont coaxiales.

14. Dispositif de refroidissement selon la revendication 11 ou 12, caractérisé en ce que sont prévues plusieurs bobines correctrices agissant dans une direction de gradient différente.

15. Dispositif de refroidissement selon l'une des revendications 10 à 14, caractérisé en ce que, par l'utilisation d'au moins une bobine correctrice (62, 66) dans la zone du réfrigérateur (11) et de l'espace pour échantillon (36), l'appareil de commande (64) commande dans une première étape la bobine correctrice (66) dans la zone du réfrigérateur (11) puis, dans une seconde étape, commande la bobine correctrice (62) dans la zone de l'espace pour échantillon (36).

16. Dispositif de refroidissement selon la revendication 1, caractérisé en ce que le passage au travers de l'enveloppe extérieure (22) est sous forme d'un dispositif coulissant étanche au vide.

17. Dispositif de refroidissement selon la revendication 16, caractérisé en ce que le bras refroidissant (18) est disposé dans un tube (17) appartenant au réfrigérateur (11), qui est coulissant dans un collier (21) adapté à l'enveloppe (22).

18. Dispositif de refroidissement selon la revendication 16, caractérisé en ce que le bras refroidissant (18) aboutit, à son extrémité tournée vers la bobine magnétique (30), d'abord dans un tronçon terminal (38) et ensuite dans un doigt concentrique (39) ayant une section transversale moindre par rapport à celle du tronçon terminal (38) et que le tronçon terminal (38) et le doigt (39), de moindre diamètre se trouve, dans la position introduite du réfrigérateur (11), en liaison mécanique avec au moins deux panneaux intermédiaires (26, 29) situés l'un derrière l'autre.

19. Dispositif de refroidissement selon la revendication 16, caractérisé en ce que le bras refroidissant (18) dispose d'un dispositif de chauffage (67).

Fig. 1

0 116 364

Fig. 2

Fig.3

Fig. 4

Fig. 5a

Fig. 5b